# EUROPEAN PATENT APPLICATION

(11) **EP 0 547 616 A1**
(43) Date of publication of application: **23.06.1993**
(21) Application number: 92121521.6
(22) Date of filing: 17.12.1992
(51) Int. Cl.: H01R 31/06

(54) **Circular connector to mass terminated connector adaptor**

(30) Priority: 19.12.1991 US 811587
(71) Applicant: Hughes Aircraft Company, Los Angeles, California 90045-0066 (US)
(72) Inventor: Smith, William A., Laguna HIlls, California 92653 (US)
(74) Representative: Grünecker, Kinkeldey, Stockmair & Schwanhäusser Anwaltssozietät

(57) **Abstract**

A connector arrangement and an adaptor (12) for interconnecting a military standard circular connector (10) to a mass terminated flat ribbon connector (38). The military standard circular connector (10) includes a housing (14) into which is disposed an array of extended circular connector pins (30) having a first predetermined pattern. The mass terminated connector (38) has an array of connector pins (42) disposed in a second predetermined pattern. The adaptor (12) includes a printed circuit board (36) to which he arrays of connector pins (30, 42) are secured. Etched conductors (50, 52) extend between and electrically connect the connector pins (30, 42) of the circular and mass terminated connectors (10, 38) to complete electrical connection between the two connectors.

## Description

### BACKGROUND

The present invention relates generally to electrical connectors, and in particular, to an adaptor incorporating a printed circuit board which adapts circular connectors to mass terminated connectors.

Currently, all military and many commercial electronics products use circular connectors of the type in which both the male and female connector incorporate complimentary rigid housings engagable one with the other and secured with a threaded coupling. These connectors are desirable because they withstand hostile working environments. The military standard circular connectors are assembled one wire at a time using either a crimped or a soldered termination. This is a time consuming and costly procedure. Another widely used electrical connector is the mass terminated connector. The mass terminated connector is typically a generally rectangular assembly including complimentary male and female connectors slideably connectable one to the other and secured by means such as screws or spring clips. These connectors are suitable for use internally within electronic products and connection of wire to a mass terminated connector is performed by cost effective automated machinery. There presently exists a need for an adaptor that will enable a military standard circular connector to be wired using automated mass terminated connector machinery and methodology.

It is therefore an objective of the invention to provide an improved electrical connector arrangement. It is another objective of the invention to provide an adaptor for military standard circular connectors which adapts the connectors for connection to mass terminated connector. Still another objective of the invention is to provide an adaptor which enables the direct connection of military standard circular connectors to mass terminated connectors. Yet another objective of the invention is to provide an adaptor for military standard circular connectors which enables wiring of the connector using automated mass terminated connector machinery and methodology. Another objective of the invention is to provide an adaptor for military standard circular connectors which enables wiring thereof at reduced cost while retaining the reliability of the circular connector. Still another objective of the invention is to provide an adaptor for military standard circular connectors which incorporates a printed circuit board supporting an array of connector pins arranged in the pattern of a military standard circular connector, the pins being received directly in a military standard circular connector and being connected to a standard mass terminated connector by etched conductors formed on the surfaces of the printed circuit board.

### SUMMARY OF THE INVENTION

Broadly, the invention is a connector arrangement that comprises two different, normally nonmatable connectors, and a printed circuit board that is adapted to mate the two connectors. The arrangement includes a first connector having a first plurality of connector pins disposed in a first predetermined pattern, and wherein the first plurality of connector pins is secured to the printed circuit board. A second connector has a second plurality of connector pins disposed in a second predetermined pattern secured to the printed circuit board. A pattern of conductors is disposed on at least one surface of the printed circuit board to electrically connect pins of the first connector to predetermined pins of the second connector.

More specifically, the invention comprises an adaptor for adapting military standard circular connectors for connection to mass terminated flat ribbon connectors. The adaptor includes a printed circuit board having pluralities of holes disposed therethrough in the pattern of the military standard circular connector and the mass terminated connector, and a pattern of etched conductors disposed on at least one surface thereof interconnecting plated through holes coupled to the conductors. A military standard circular connector has an array of connector pins disposed in a predetermined pattern, and the array of connector pins is secured to the printed circuit board at the location of a selected plurality of holes. A mass terminated connector having a plurality of mass terminated connector pins is secured to the printed circuit board at the location of another selected plurality of holes.

### BRIEF DESCRIPTION OF THE DRAWINGS

The various features and advantages of the present invention may be more readily understood with reference to the following detailed description taken in conjunction with the accompanying drawings, wherein like reference numerals designate like structural elements, and in which:
FIG. 1 is a side plan view of a military standard circular connector fitted with the adaptor of the present invention partially shown in a sectional view to illustrate details of the connector and adaptor;
FIG. 2 is an end view of the connector and adaptor shown from the front end;
FIG. 3 is an exploded perspective view of the connector and adaptor of the present invention;
FIG. 4 is a plan view of one surface of a typical adaptor printed circuit board;
FIG. 5 is a plan view of the opposite surface of the printed circuit board of FIG. 4; and
FIG. 6 is a fragmentary sectional view showing details of the attachment of connector pins to the adaptor printed circuit board.

### DETAILED DESCRIPTION

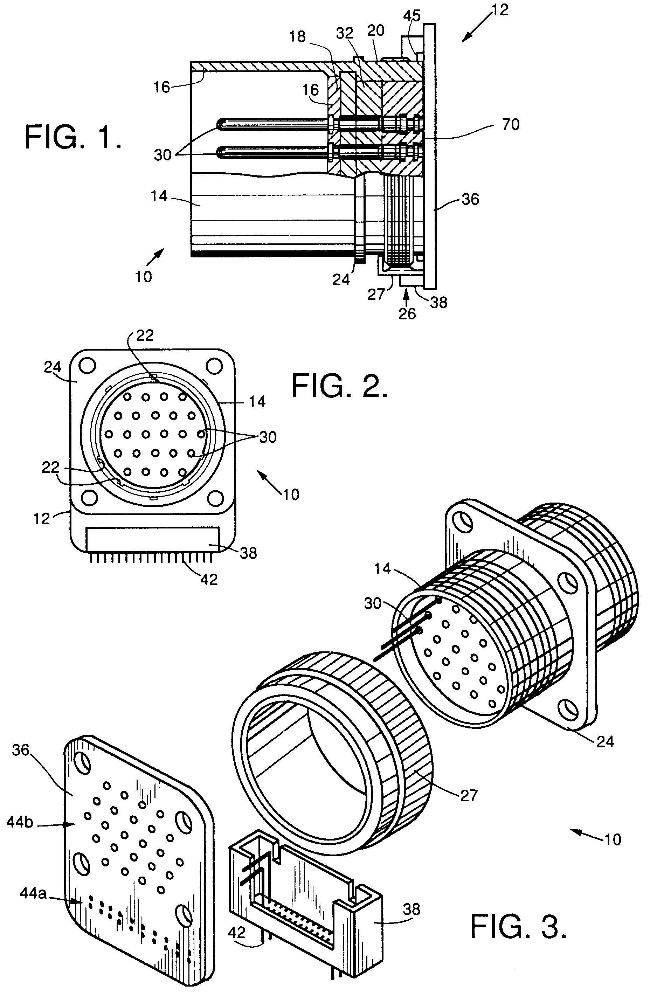

Referring now to the drawings, there is shown in FIG. 1 a partially sectionalized view of a portion of a military standard circular connector 10 and a mass terminated flat ribbon connector 38 to which is attached a military standard circular connector to mass terminated connector adaptor 12. FIG. 2 shows an end view of the connectors 10, 38 and adaptor 12 shown from the front end. The circular connector 10 comprises a hollow cylindrical housing, or shell 14, which has an interfacial seal 16, a front pin insert 18 and rear insert 20 disposed therein in a conventional manner well known to those knowledgeable about military standard connectors 10. The shell 14 is provided with one or more polarizing keyways 22, shown in FIG. 2 only, and a rectangular mounting flange 24, both formed as an integral part of the shell 14. An end 26 of the shell 14 has threads 28 for attachment of a threaded collar 27 that assists in securing the connector 10 to the adaptor 12. In this typical prior art military standard circular connector 10, the connector 10 includes an array of connector pins 30 arranged in a predetermined pattern, and wherein the pins 30, the interfacial seal 16, and the front and rear inserts 18, 20 are secured within the shell 14 by an insert retaining ring 32. The full details of the conventional military standard circular connector 10 are well known in the connector art, and the full details of its construction will not be fully discussed.

Also shown in FIG. 1 is a portion of the mass terminated connector 38 which is attached to the adaptor 12 by means of solder, for example. The mass terminated connector 38 is located below the circular connector 10 (as shown in FIG. 1), and is more clearly illustrated in FIG. 2. FIG. 2 shows the location of the mass terminated connector 38 on the adaptor 12 and illustrates the location and orientation of its connector pins 42. The mass terminated connector 38 is a right angle connector that permits insertion of a mating connector (not shown) from below (as shown in FIG. 2).

FIG. 3 is an exploded perspective view of the connectors 10, 38 and adaptor 12 of the present invention. FIG. 3 shows more clearly the adaptor 12 which has a printed circuit board 36 having holes 44 in the form of two different hole patterns 44a, 44b, one for each connector 10, 38. The pins 30 of the circular connector 10 are shown that extend through the corresponding pattern 44b of holes 44 in the printed circuit board 36. The relative location of the mass terminated connector 38 having its connector pins 42 is shown in more detail. The relative locations of sets of four through holes located in the flange 24 and in the printed circuit board 36 are shown. The through holes in the printed circuit board 36 allow tightening of screws (not shown) that secure the flange 24 to a bulkhead (not shown) during normal use of the present invention.

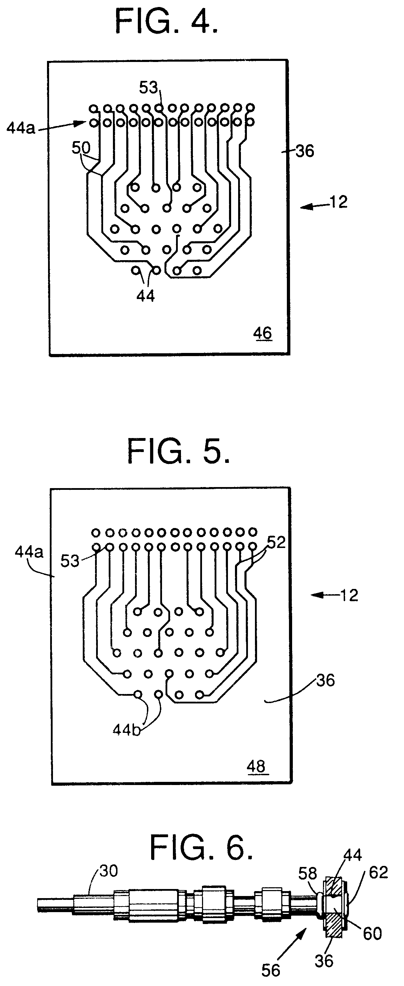

FIGS. 4 and 5 show two plan views of the adaptor 12 in accordance with the principles of the present invention. In accordance with the invention, the circular connector to mass terminated connector adaptor 12 comprises the printed circuit board 36 having the mass terminated connector 38 secured to one of its surfaces by means such as screws or by soldering, for example. The mass terminated connector 38 includes a multiplicity of pins 42 which extend through complimentary holes 44a in the printed circuit board 36. The printed circuit board 36 is further provided with a multiplicity of vias or through holes 44b which are formed in a pattern of the pin array of the circular connector 10 with which the adaptor 12 is used.

As best seen in FIGS. 4 and 5, opposite surfaces 46, 48 of the printed circuit board 36 have etched conductors 50, 52, formed thereon, and there is one conductor 50, 52 extending from each of the holes 44a to a corresponding hole 44b. The ends of the conductors 50, 52 terminate in solder pads 53. The conductors 50, 52 may be formed on one or both surfaces 46, 48 of the printed circuit board 36 as required.

With reference to FIG. 6, the specially fabricated connector pin 30 is provided with a first flange 58 adjacent an end 56 and a printed circuit connector portion 60 that is received through a hole 44 in the printed circuit board 36. The pin 30 may be secured to the printed circuit board 36 by deforming the distal end of the printed circuit connector portion 60 to form a second flange 62. Alternatively, the pin 30 may be soldered to the printed circuit board 36. When all of the pins 30 have been secured to the printed circuit board 36, the assembly is flow soldered, for example. However, it is to be understood that both connectors 10, 38 may be secured to the printed circuit board 36, which is then reflow soldered, for example, to solder all connector pins 30, 42.

Referring again to FIGS. 1 and 2, the printed circuit board 36, including the mass terminated connector 38 and the pins 30, is additionally secured to the circular connector 10 by means of the flanged cylindrical collar 27. Insertion of the circular connector pins 30 into the circular connector shell 14 is effected simply and after the circular connector shell 14 has been mounted to an electronic assembly panel or bulkhead. A suitable sheet insulator 45 may be disposed between the printed circuit board 36 and the circular connector 10 to provide electrical isolation.

Using the adaptor 12 of the present invention, connections may be made between a military standard circular connector 10 and the mass terminated connector 38. This enables the use of automated assembly techniques, which are widely available for connecting cables to mass terminated connectors 38, for connection to military standard circular connectors 10. This results in substantial savings in labor and assembly time. The adaptor 12 facilitates the installation of conventional installation of military standard connectors 10 used for external connection to an electronic assembly and provides secure automated connection within the electronic assemblies using mass terminated connectors 38.

Thus there has been described a new and improved adaptor for adapting military standard circular connectors for connection to mass terminated connectors. It is to be understood that the above-described embodiment is merely illustrative of some of the many specific embodiments which represent applications of the principles of the present invention. Clearly, numerous and other arrangements can be readily devised by those skilled in the art without departing from the scope of the invention.

## Claims

1. A circular connector (10) to mass terminated connector (38) adaptor (12) characterized by:
a printed circuit board (36);
a circular connector (10) having an array of connector pins (30) disposed in a predetermined pattern, and wherein the array of connector pins (30) is fixedly secured to the printed circuit board (36);
a mass terminated connector (38) having a plurality of mass terminated connector pins (42) fixedly secured to the printed circuit board (36); and
a pattern of etched conductors (50, 52) disposed on at least one surface of the printed circuit board (36) electrically connecting pins (30) of the circular connector (10) to predetermined pins (42) of the mass terminated connector (38).

2. The adaptor (12) of Claim 1 further characterized by a connector housing (14), the pins of the array of connector pins (30) being received in the connector housing (14) in a predefined circular connector pin array pattern and position.

3. The adaptor (12) of Claim 2 wherein the printed circuit board (36) is characterized by a first array of holes (44b) therethrough arranged in the pin pattern of the circular connector (10) and a second array of holes (44a) therethrough arranged in the pattern of the pins of the mass terminated connector (38), the array of connector pins (30) being received in the first array of holes (44b) and the pins of the mass terminated connector (38) being received in the second array of holes (44a).

4. The adaptor (12) of Claim 3 wherein the connector pins (30) are secured to the printed circuit board by deforming the ends thereof.

5. The adaptor (12) of Claim 4 wherein the connector pins (30) and mass terminated connector pins are soldered to respective ends of the conductors (50, 52).

6. The adaptor (12) of Claim 5 wherein the connector pins (30) and the mass terminated connector (38) extend outwardly from the same surface of the printed circuit board (36).

7. The adaptor (12) of Claim 6 wherein the printed circuit board (36) is characterized by electrical conductors (50, 52) disposed on both surfaces thereof.

8. The adaptor of Claim 7 wherein each of the circular connector pins (30) is characterized by a first flange (58) disposed in spaced relationship adjacent one end thereof and encasing one surface (46) of the printed circuit board (36), a printed circuit portion (60) received through a respective one of the first array of holes (44a), and a deformed second flange (62) engaging the other surface (48) of the printed circuit board (36).

9. A connector arrangement characterized by:
a printed circuit board (36);
a first connector (10) having an first plurality of connector pins (30) disposed in a first predetermined pattern, and wherein the first plurality of connector pins (30) is fixedly secured to the printed circuit board (36);
a second connector (38) having a second plurality of connector pins (42) disposed in a second predetermined pattern fixedly secured to the printed circuit board (36); and
a pattern of conductors (50, 52) disposed on at least one surface of the printed circuit board (36) electrically connecting pins of the first connector (10) to predetermined pins of the second connector (38).

10. The connector arrangement of Claim 9 wherein the printed circuit board (36) is characterized by a first array of holes (44a) therethrough arranged in the first predetermined pattern and a second array of holes (44b) therethrough arranged in the second predetermined pattern, and wherein individual connector pins (30, 42) of each respective connector are disposed in respective ones of the holes (44a, 44b) of its mating pattern.

11. The connector arrangement of Claim 10 wherein the first plurality of connector pins (30) are secured to the printed circuit board (36) by deforming one end thereof.

12. The connector arrangement of Claim 11 wherein the first and second pluralities of connector pins (30, 42) are soldered to the electrical conductors (50, 52).

13. The connector arrangement of Claim 12 wherein the printed circuit board (36) has electrical conductors (50, 52) disposed on both surfaces thereof.

14. The connector arrangement of Claim 13 wherein each of the first plurality of connector pins (30) is characterized by a first flange (58) formed therein in spaced relationship to one end of the connector pin (30), a printed circuit portion (60) extending through a respective one of the first array of holes (44a), and a deformed second flange (62) engaging the other surface of the printed circuit board (36).
